# EUROPEAN PATENT APPLICATION

(11) **EP 3 379 582 A1**
(43) Date of publication of application: **26.09.2018**
(21) Application number: 18152732.6
(22) Date of filing: 22.01.2018
(51) Int. Cl.: H01L 31/02

(54) **DOUBLE-SIDED LIGHT RECEIVING SOLAR CELL MODULE**

(30) Priority: 23.03.2017 KR 20170036847
(71) Applicant: LG Electronics Inc., Seoul 07336 (KR)
(72) Inventor: PARK, Sanghwan, 08592 Seoul (KR); LYU, Eonjoo, 08592 Seoul (KR); KIM, Sukwon, 08592 Seoul (KR)
(74) Representative: Katérle, Axel

(57) **Abstract**

A double-sided light receiving solar cell module is disclosed, and includes a plurality of solar cells connected to each other by a plurality of conductive wirings in a first direction to form each cell string, a junction box configured to collect power generated from the plurality of solar cells and supply the collected power to outside, and a plurality of conducting wires having one end connected to the plurality of conductive wirings connected to a last solar cell of the each cell string and another end connected to the junction box. The junction box and the conducting wires are disposed outside a projection area of the solar cells. The conducting wires include first directional portions extending in the first direction and second directional portions extending in a second direction outside the projection area. The second directional portions provided on at least one of the conducting wires overlap the junction box.

## Description

This application claims priority to and the benefit of Korean Patent Application No. 10-2017-0036847 filed in the Korean Intellectual Property Office on March 23, 2017, which is hereby incorporated by reference in its entirety.

### STATEMENT REGARDING SPONSORED RESEARCH OR DEVELOPMENT

This work was supported by the Korea Institute of Energy Technology Evaluation and Planning (KETEP) and the Ministry of Trade, Industry & Energy (MOTIE) of the Republic of Korea (No. 20163010012430).

### BACKGROUND OF THE INVENTION

### Field of the Invention

Embodiments of the invention relate to a double-sided light receiving solar cell module.

### Background of the Related Art

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted.

A solar cell generally includes semiconductor parts, which respectively have different conductive types, for example, a p-type and an n-type and thus form a p-n junction, and electrodes respectively connected to the semiconductor parts of the different conductive types.

When light is incident on the solar cell, a plurality of electron-hole pairs are produced in the semiconductor parts and are separated into electrons and holes by the incident light. The electrons move to the n-type semiconductor part, and the holes move to the p-type semiconductor part. Then, the electrons and the holes are collected by the different electrodes respectively connected to the n-type semiconductor part and the p-type semiconductor part. The electrodes are connected to each other using electric wires to thereby obtain electric power.

A plurality of such solar cells may be connected to each other by an interconnector to form a cell string. A conducting wire connecting the cell string and a junction box disposed outside a solar cell module is connected at an end of the cell string.

On the other hand, among the conventional solar cell modules, the double-sided light receiving solar cell module receives light from a front side as well as a back side of the module. Therefore, the conducting wire and the junction box are disposed in an area that does not overlap a position of the solar cell in order not to block an area where the solar cell receives light from front and back sides of an inside of the module.

However, in such an instance, because the area of the solar cell module irrelevant to the power generation becomes relatively large, the efficiency of the module relatively decreases. There is a problem that the weight of the module is increased due to a wider area of the module.

### SUMMARY OF THE INVENTION

An object of the invention is to provide a double-sided light receiving solar cell module that minimizes an increase in an area irrelevant to power generation.

In one aspect, there is provided a double-sided light receiving solar cell module including a plurality of solar cells connected to each other by a plurality of conductive wirings in a first direction to form each cell string, a junction box configured to collect power generated from the plurality of solar cells and supply the collected power to outside, and a plurality of conducting wires having one end connected to the plurality of conductive wirings connected to a last solar cell of the each cell string and having another end connected to the junction box. The junction box and the plurality of conducting wires are disposed outside a projection area of the plurality of solar cells. The plurality of conducting wires include first directional portions extending in the first direction and second directional portions extending in a second direction intersecting with the first direction outside the projection area. The second directional portions provided on at least one of the plurality of conducting wires overlap the junction box.

The plurality of conductive wirings may be arranged along the first direction, and the plurality of conductive wirings connected to the last solar cell of the each cell string may be connected to the second directional portions of the plurality of conducting wires.

The plurality of conducting wires may include outer conducting wires connected to a conductive wiring connected to a last solar cell of an outermost cell string located on an outermost side of the each cell string and inner conducting wires connected to a conductive wiring connected to a last solar cell of an inner cell string located inside the outermost cell string.

The outer conducting wires and the inner conducting wires each may include the second directional portions, and a first gap between the second directional portions of the outer conducting wires and the last solar cell of the outermost cell string may be greater than a second gap between the second directional portions of the inner conducting wires and the last solar cell of the inner cell string.

A difference between the first gap and the second gap may be greater than a line width of the inner conducting wires, and may be less than twice the line width of the inner conducting wires.

An outermost protruding length of the conductive wiring connected to the last solar cell of the outermost cell string may be longer than an inner protruding length of the conductive wiring connected to the last solar cell of the inner cell string.

The outermost protruding length may be greater than 1.5 times the inner protruding length, and less than three times the inner protruding length.

A line width of each of the plurality of conducting wires may be greater than a line width of each of the conductive wirings.

A ratio of the line width of each of the plurality of conductive wirings to the line width of each of the plurality of conducting wires may be 1:15 to 25.

The plurality of conducting wires each further may include the first directional portions extending in the first direction intersecting with the second directional portions at ends of the second directional portions, and a ratio of the first directional portions to the second directional portions may be 1: 6 to 15.

The solar cell module further may include a front transparent member disposed on a front side of the plurality of solar cells, a back member disposed on a back side of the plurality of solar cells, sealing members disposed between the plurality of solar cells and the front transparent member and disposed between the plurality of solar cells and the back member, and a frame disposed to surround outer edge portions of the front transparent member, the sealing members, and the back member. The back member may be transparent.

The junction box may be disposed at an upper portion of a back side of the solar cell module. When the solar cell module is viewed from a front view, a distance from the frame disposed at an upper portion of the solar cell module to the junction box may be greater than a distance from the frame disposed at a lower portion of the solar cell module to the last solar cell of the each cell string.

The frame may include a first portion disposed to cover a front edge portion of the front transparent member, a second portion extending from an end of the first portion, and disposed to cover sides of the front transparent member, the sealing members, and the back member, and a third portion extending from the second portion, and disposed to cover a back edge portion of the back member.

The first directional portion included each of the plurality of conducting wires may penetrate the back member and may be connected to a terminal provided in the junction box.

The front transparent member may include a glass material and the back member may include a resin material that is lighter than the glass material.

The plurality of solar cells may be spaced apart in the first direction in the each cell string, and a gap of the plurality of solar cells in the first direction may be less than the second gap.

When the solar cell module is viewed from a front view, a distance from the frame disposed at an upper portion of the solar cell module to the junction box may be greater than a second gap between second directional portions of inner conducting wires and a last solar cell of an inner cell string.

In the solar cell module according to the invention, the plurality of conducting wires do not overlap the solar cell, and the second directional portions provided in a direction intersecting with a longitudinal direction of the cell string overlap the junction box. Thus, the increase in the area of the module, which is irrelevant to the power generation, can be minimized.

### BRIEF DESCRIPTION OF THE DRAWINGS

FIG. 1 includes (a) illustrating a front view of a double-sided light receiving solar cell module, and (b) illustrating a back view of a double-sided light receiving solar cell module.
FIG. 2 illustrates an exploded perspective view of a double-sided light receiving solar cell module.
FIG. 3 is a view for explaining a cell string.
FIG. 4 includes (a) illustrating a plan view and (b) illustrating a side view of diagrams for explaining connection structure of each solar cell and a conductive wiring.
FIG. 5 includes (a) illustrating an upper portion of a front view of a double-sided light receiving solar cell module in more detail, and (b) illustrating a lower portion of a front view of a double-sided light receiving solar cell module in more detail.
FIG. 6 is an enlarged view of second directional portions and first directional portions of outer conducting wires and inner conducting wires, respectively.
FIG. 7 illustrates a cross section of a CS-CS line in (a) of FIG. 5.

### DETAILED DESCRIPTION OF THE EMBODIMENTS

Reference will now be made in detail to embodiments of the invention, examples of which are illustrated in the accompanying drawings. This invention may, however, be embodied in many different forms and should not be construed as limited to the embodiments set forth herein. Wherever possible, the same reference numbers will be used throughout the drawings to refer to the same or like parts. It will be noted that a detailed description of known arts will be omitted if it is determined that the detailed description of the known arts can obscure the embodiments of the invention.

In the drawings, the thickness of layers, films, panels, regions, etc., are exaggerated for clarity. It will be understood that when an element such as a layer, film, region, or substrate is referred to as being "on" another element, it can be "directly on" the other element or intervening elements may also be present. In contrast, when an element is referred to as being "directly on" another element, there are no intervening elements present. Further, it will be understood that when an element such as a layer, film, region, or substrate is referred to as being "entirely" on other element, it may be on the entire surface of the other element and may not be on a portion of an edge of the other element.

In the following description, "front side" of a component may be one side of a module, on which light is directly incident, and "back side" of a component may be a side opposite the one side of the module, on which light is not directly incident or reflective light may be incident.

In the following description, the fact that a thickness or a width of a component is equal to a thickness or a width of another component indicates that they have the same value within a margin of error of 10 % including a process error.

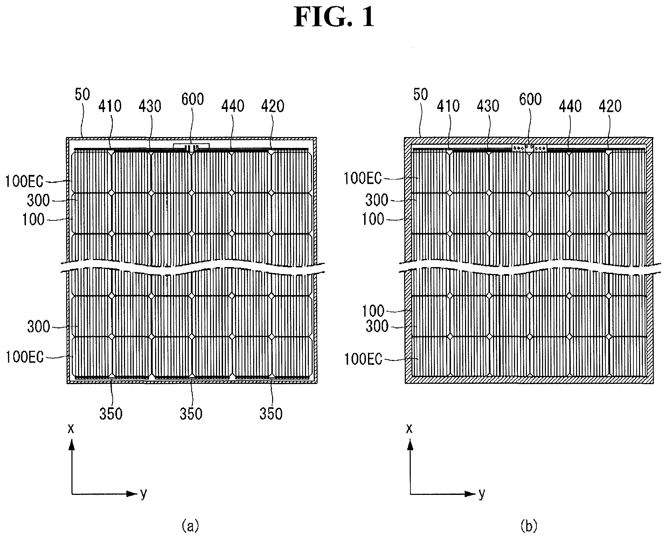

FIGS. 1 to 4 illustrate a double-sided light receiving solar cell module according to an embodiment of the invention.

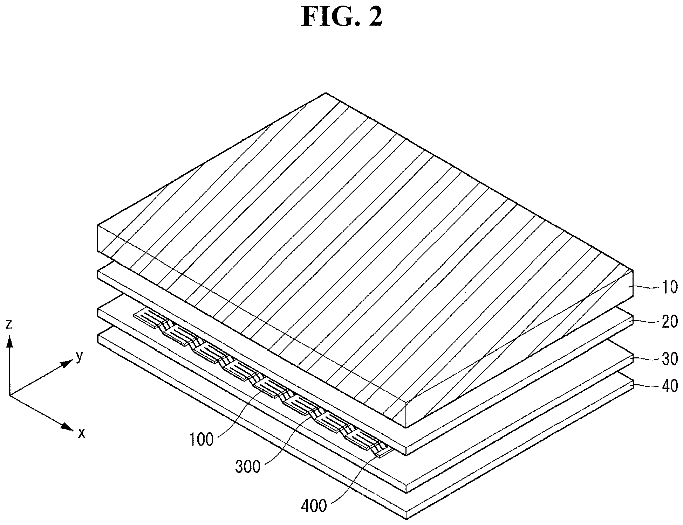

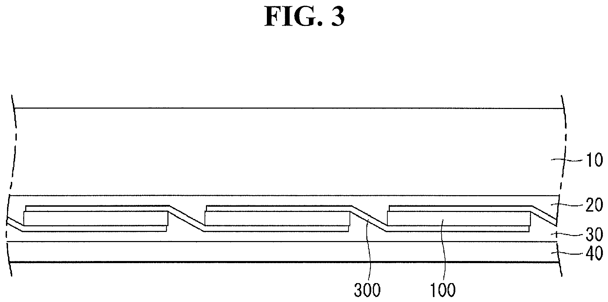

FIG. 1 includes (a) illustrating a front view of a double-sided (or bifacial) light receiving solar cell module, and (b) illustrating a back view of a double-sided light receiving solar cell module. FIG. 2 illustrates an exploded perspective view of a double-sided light receiving solar cell module. FIG. 3 is a view for explaining a cell string.

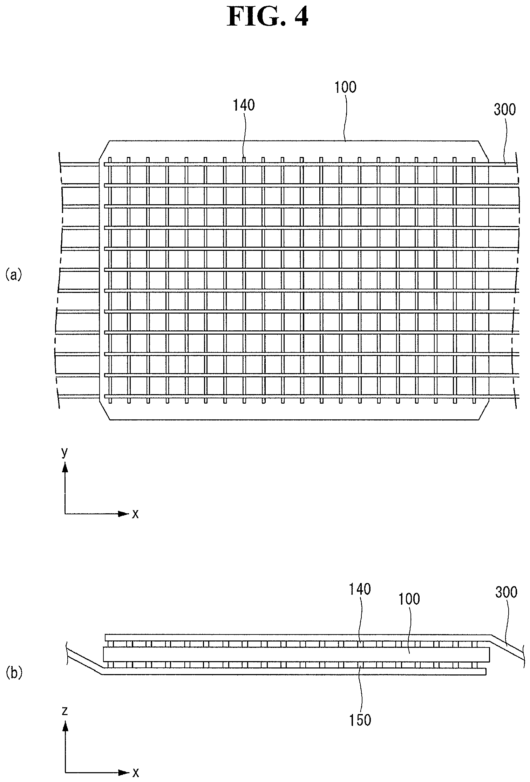

FIG. 4 includes (a) illustrating a plan view and (b) illustrating a side view of diagrams for explaining connection structure of each solar cell 100 and a conductive wiring 300. In FIG. 4, (a) is a view illustrating a structure in which a conductive wiring 300 is connected to a solar cell 100 from a front view of a solar cell 100. In FIG. 4, (b) is a view illustrating a structure in which a conductive wiring 300 is connected to a solar cell 100 from a cross section of a solar cell 100. In embodiments of the invention, each solar cell 100 may be a bifacial solar cell to receive incident light from both sides.

As shown in FIGS. 1 to 4, an embodiment of a solar cell module according to the invention includes a front transparent member 10, sealing members 20 and 30, a back member 40, a frame 50, a plurality of solar cells 100, and conducting wires 410, 420, 430, and 440.

As shown in FIGS. 1 to 3, the front transparent member 10 may be disposed on a front side of the plurality of solar cells 100 and may include a transparent glass material. For example, the front transparent member 10 may be formed of tempered glass or the like having a high transmittance and excellent breakage-preventing function.

As shown in FIGS. 1 to 3, the sealing members 20 and 30 may include a front sealing member 20 disposed between the plurality of solar cells 100 and the front transparent member 10 and a back sealing member 30 disposed between the plurality of solar cells 100 and the back member 40.

The sealing members 20 and 30 may be formed of a transparent material such that light incident through the front transparent member 10 and light incident through the back member 40 are incident on the plurality of solar cells 100. The sealing members 20 and 30 can prevent corrosion due to moisture penetration and protect the solar cell 100 from impact, and can absorb shocks therefor. The sealing materials 20 and 30 may be formed of at least one material selected from transparent ethylene vinyl acetate (EVA) or polyolefin (POE). Other materials may be used. The sealing materials 20 and 30 may be formed in a form of a sheet for convenience of manufacturing process.

The sheet-shaped sealing members 20 and 30 are disposed between the front transparent member 10 and the solar cell 100 and between the solar cell 100 and the back member 40, and can be softened and hardened by heat and pressure during a lamination process.

As shown in FIGS. 1 to 3, the back member 40 is disposed on a back side of the plurality of solar cells 100. The back member 40 may be made of a transparent material so that light is received by a back side of the module. In order to reduce weight of the module, the back member 40 may be formed of a sheet including a resin material that is lighter than glass.

However, the back member 40 is not limited to the sheet made of resin but may be formed of glass or other materials.

The back member 40 prevents moisture from penetrating the back side of the solar cells 100, thereby protecting the solar cell 100 from an external environment. The back member 40 may have a multi-layer structure such as a layer preventing moisture and oxygen penetration, and a layer preventing chemical corrosion, for example.

The back member 40 may be formed of a thin sheet made of an insulating material such as fluoropolymer (FP) or polyester (PE). Other materials may be used.

As shown in FIG. 1, the frame 50 is disposed to surround outer edge portions of the front transparent member 10, the sealing members 20 and 30, and the back member 40, and can protect the front transparent member 10, the sealing members 20 and 30, and the back member 40 from an external impact.

The frame 50 may be formed of at least one material of reinforced plastic, steel, or stainless steel.

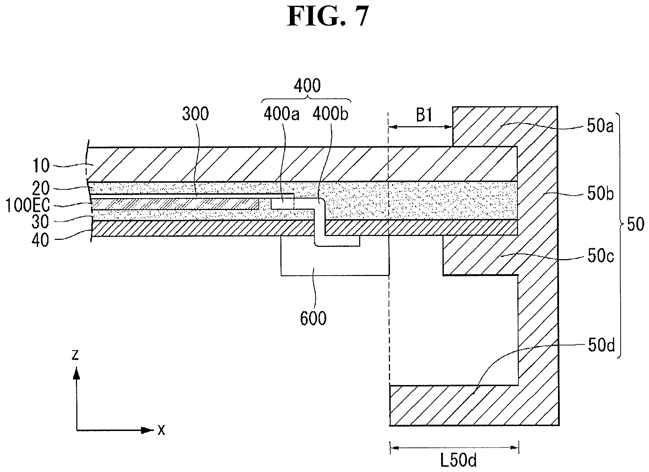

A structure of the frame 50 will be described in more detail with reference to FIG. 7.

The plurality of solar cells 100 are disposed between the front sealing member 20 and the back sealing member 30 and can generate electric power from incident light.

As shown in FIGS. 1 and 3, each of the plurality of solar cells 100 may be connected to each other by a plurality of conductive wirings 300 in a first direction x to form each cell string to improve or increase voltages.

In each of the plurality of solar cells 100, as shown in (a) of FIG. 4, a first electrode 140 may be disposed on the front side of the solar cell 100 and a second electrode 150 may be disposed on the back side of the solar cell 100. The second electrode 150 may have a polarity different from that of the first electrode.

Here, as shown in (a) of FIG. 4, each of the first and second electrodes 140 and 150 of the solar cell 100 may be disposed in a stripe shape in a second direction y that intersects with a longitudinal direction of the conductive wiring 300.

The plurality of conductive wirings 300 are arranged long in the first direction x and may be connected to the first electrode 140 or the second electrode 150 through a conductive adhesive such as a solder paste.

The plurality of conductive wirings 300 may be coated with a coating layer including a solder material on a core such as copper and connected to the first electrode 140 or the second electrode 150. Other materials for the coating layer and the core may be used.

As shown in FIG. 4, the plurality of conductive wirings 300 are connected to the first electrode 140 and the second electrode 150 of each solar cell 100 adjacent to each other in the first direction x, and can form respective cell strings.

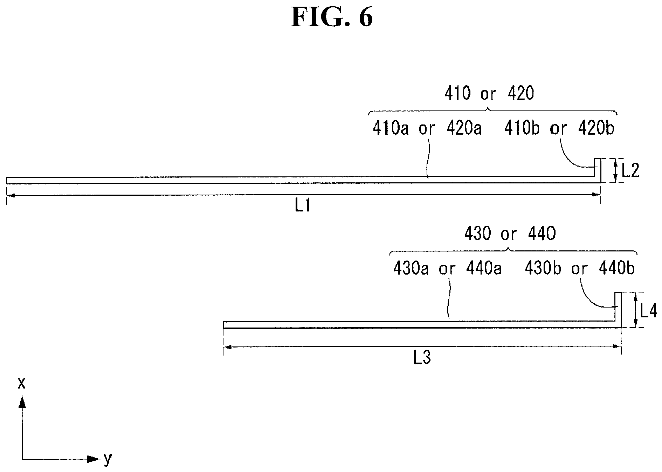

As shown in (a) and (b) of FIG. 1, the each cell string may be arranged long in the first direction x and spaced in the second direction y. In embodiments of the invention, the number of the cell string is not limited, and as shown in FIG. 1, 6 cell strings may be included in the solar cell module. The 6 cell strings may be symmetrically arranged to have 3 cell strings on each side of the solar cell module.

In each of a plurality of conducting wires 410, 420, 430, as shown in (a) and (b) of FIG. 1, one end may be connected to the plurality of conductive wirings 300 connected to a last solar cell 100 of the each cell string disposed at an upper portion of the module, and another end may be connected to a junction box 600 through the back member 40.

As shown in FIG. 1, a busing bar 350 for connecting the each cell string in series in the second direction y may be further provided at a lower portion of the module.

As shown in FIG. 2, the front transparent member 10, the sealing members 20 and 30, the back member 40, the plurality of solar cells 100, the busing bar 350, and the plurality of conducting wires 410, 420, 430, and 440 are sequentially disposed and can be thermally pressed and integrated during the lamination process. The front transparent member 10, the sealing members 20 and 30, the back member 40, the plurality of solar cells 100, and the plurality of conducting wires 410, 420, 430 and 440 which are integrated, are packaged by the frame 50.

The junction box 600 may collect power generated from the plurality of solar cells 100 and supply the collected power to outside. As shown in FIG. 1, the junction box 600 may be disposed at the back side of the module, that is, at an upper portion of the back side of the back member 40.

Specifically, the junction box 600 may be disposed outside a projection area of the plurality of solar cells 100 in the upper portion of the back side of the module. That is, more specifically, the junction box 600 may be disposed in an area between the frame 50 and the solar cell 100 in the upper portion of the back side of the module.

By disposing the junction box 600 outside the projection area of the plurality of solar cells 100 in the upper portion of the back side of the module, it is possible to prevent light from being blocked by the junction box 600 when the light is incident on the back side of the module.

On the other hand, as shown in (a) and (b) of FIG. 1, in the double-sided light receiving solar cell module of the invention, the plurality of conducting wires 410, 420, 430, and 440 may be disposed outside the projection area of the plurality of solar cells 100, and may be disposed in an area between the frame 50 and the solar cell 100. A portion of the plurality of conducting wires 410, 420, 430, 440 extending in the second direction y may overlap the junction box 600 to minimize an increase in an area irrelevant to power generation in the module.

Thus, the efficiency of the double-sided light receiving solar cell module can be further improved.

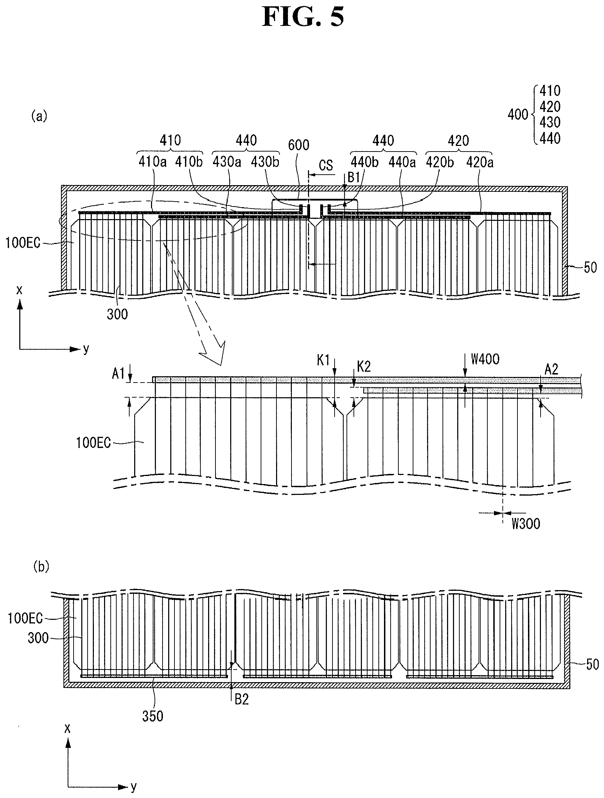

Hereinafter, the specific structure of the plurality of conducting wires 410, 420, 430, and 440 will be described in more detail with reference to FIGS. 5 to 7.

In FIG. 5, (a) illustrates an upper portion of a front view of a double-sided light receiving solar cell module in more detail. In FIG. 5, (b) illustrates a lower portion of a front view of a double-sided light receiving solar cell module in more detail.

FIG. 6 is an enlarged view of second directional portions and first directional portions of outer conducting wires 410 and 420 and inner conducting wires 430 and 440, respectively.

FIG. 7 illustrates a cross section of a CS-CS line in (a) of FIG. 5.

As shown in (a) of FIG. 5, a plurality of conducting wires 410, 420, 430 and 440 according to the invention may include outer conducting wires 410 and 420 and inner conducting wires 430 and 440.

Here, the outer conducting wires 410 and 420 may be connected to a conductive wiring 300 connected to a last solar cell 100EC of an outermost cell string located on an outermost side of cell strings. The inner conducting wires 430 and 440 may be connected to a conductive wiring 300 connected to a last solar cell 100EC of an inner cell string located inside the outermost cell string.

Here, the outermost cell string refers to a cell string located at an outermost edge of a plurality of cell strings spaced apart in a second direction. The inner cell string refers to a cell string located inside the outermost cell string among the plurality of cell strings in the second direction.

The plurality of conducting wires 410, 420, 430, and 440 may be disposed outside a projection area of a plurality of solar cells 100, but may be disposed in an area between a frame 50 and the solar cells 100.

The plurality of conducting wires 410, 420, 430, and 440 may include second directional portions 410a, 420a, 430a, and 440a extending in the second direction y in outside the projection area of the plurality of solar cells 100, that is, the area between the frame 50 and the solar cells 100. The plurality of conducting wires 410, 420, 430, and 440 may include first directional portions 410b, 420b, 430b, and 440b extending in a first direction x intersecting with the second directional portions 410a, 420a, 430a, and 440a at ends of the second directional portions 410a, 420a, 430a, and 440a.

More specifically, the outer conducting wires 410, 420 and the inner conducting wires 430, 440 each include the second directional portions 410a, 420a, 430a, 440a extending in the second direction y, and the first directional portions 410b, 420b, 430b, 440b extending in the first direction x at the ends of the second directional portions 410a, 420a, 430a, and 440a.

Here, the second directional portions 410a, 420a, 430a, and 440a of the conducting wires 410, 420, 430, and 440 may be connected to a plurality of conductive wirings 300 connected to a last solar cell 100EC of each cell string located at an upper portion of a module.

Parts of the first directional portions 410b, 420b, 430b and 440b of the respective conducting wires 410, 420, 430 and 440 penetrate a back member 40 and are connected to connection terminals of a junction box 600.

The second directional portions 410a, 420a, 430a, and 440a provided on at least one of the plurality of conducting wires 410, 420, 430, and 440 may overlap the junction box 600.

As shown in (a) of FIG. 5, both of the second directional portions 410a and 420a of the outer conducting wires 410 and 420 and the second directional portions 430a and 440a of the inner conducting wires 430 and 440 may overlap the junction box 600.

However, the invention is not limited to this. The second directional portions 410a and 420a of the outer conducting wires 410 and 420 may overlap the junction box 600. The second directional portions 430a and 440a of the inner conducting wires 430 and 440 do not overlap the junction box 600 and may be disposed in an area between the junction box 600 and the solar cells 100.

As described above, the second directional portions 410a, 420a, 430a, 440a of the plurality of conducting wires 410, 420, 430, 440 extending in the second direction y overlap the junction box 600, so that it is possible to minimize an increase in an area irrelevant to power generation in the module.

In order to implement such a structure, a first gap A1 between the second directional portions 410a and 420a of the outer conducting wires 410 and 420 and the last solar cell 100EC of the outermost cell string may be formed greater than a second gap A2 between the second directional portions 430a and 440a of the inner conducting wires 430 and 440 and the last solar cell 100EC of the inner cell string.

More specifically, a difference between the first gap A1 and the second gap A2 may be greater than a line width W400 of the inner conducting wires 430 and 440, and may be less than twice the line width W400 of the inner conducting wires 430 and 440.

Here, for example, the line width W400 of the inner conducting wires 430 and 440 and the line width W400 of the outer conducting wires 410 and 420 may be equal to each other.

Thus, it is possible to secure a space in which the second directional portions 430a and 440a of the inner conducting wires 430 and 440 can be disposed between the second directional portions 410a and 420a of the outer conducting wires 410 and 420 and the last solar cell 100EC of the outermost cell string.

To this end, the conductive wiring 300 connected to the last solar cell 100EC of the outermost cell string may protrude in a direction of the outer conducting wires 410 and 420, and the conductive wiring 300 connected to the last solar cell 100EC of the inner cell string may protrude in a direction of the inner conducting wires 430 and 440.

Here, an outermost protruding length K1 of the conductive wiring 300 connected to the last solar cell 100EC of the outermost cell string may be longer than an inner protruding length K2 of the conductive wiring 300 connected to the last solar cell 100EC of the inner cell string.

That is, the conductive wiring 300 connected to the last solar cell 100EC of the outermost cell string may protrude further from the last solar cell 100EC of the cell string in the first direction x than the conductive wiring 300 connected to the last solar cell 100EC of the inner cell string.

For example, the outermost protruding length K1 may be greater than 1.5 times the inner protruding length K2, and less than three times the inner protruding length K2.

Further, the plurality of solar cells may be spaced apart in the first direction x in the each cell string. A gap of the plurality of solar cells in the first direction x may be less than the second gap A2.

In addition, in the solar cell module according to the invention, the plurality of conductive wirings 300 may be connected to each of the conducting wires 410, 420, 430, and 440. For example, 10 to 30 conductive wirings 300 may be connected to each of the conducting wires 410, 420, 430, and 440.

In this instance, when the line width W400 of the conducting wires 410, 420, 430, and 440 is equal to a line width W300 of the conductive wirings 300, series resistance of the conducting wires 410, 420, 430, and 440 increases, so that efficiency of the module may deteriorate. To prevent this, the line width W400 of each of the plurality of conducting wires 410, 420, 430 and 440 is formed to be greater than the line width W300 of each of the conductive wirings 300 as shown in (a) of FIG. 5.

For example, a ratio of the line width W300 of each of the conductive wirings 300 to the line width W400 of each of the plurality of conducting wires 410, 420, 430, and 440 may be 1:15 to 25.

In addition, as shown in FIG. 6, a length L1 of the second directional portions 410a and 420a of the outer conducting wires 410 and 420 may be greater than a length L3 of the second directional portions 430a and 440a of the inner conducting wires 430 and 440. A length L2 of the first directional portions 410b and 420b of the outer conducting wires 410 and 420 may be less than a length L4 of the first directional portions 430b and 440b of the inner conducting wires 430 and 440.

For example, the length L1 of the second directional portions 410a and 420a of the outer conducting wires 410 and 420 may be 1.3 to 1.7 times the length L3 of the second directional portions 430a and 440a of the inner conducting wires 430 and 440. The length L2 of the first directional portions 410b and 420b of the outer conducting wires 410 and 420 may be 0.75 to 0.85 times the length L4 of the first directional portions 430b and 440b of the inner conducting wires 430 and 440.

In addition, a ratio of the length L2 or L4 of the first directional portions 410b, 420b, 430b, and 440b of each of the conducting wires 410, 420, 430, and 440 to the length L1 or L3 of the second directional portions 410a, 420a, 430a, and 440a of each of the conducting wires 410, 420, 430, and 440 may be 1: 6 to 15.

For example, a ratio of the length L2 of the first directional portions 410b and 420b of the outer conducting wires 410, 420 to the length L1 of the second directional portions 410a and 420a of the outer conductors 410 and 420 may be 1:12 to 15. A ratio of the length L4 of the first directional portions 430b and 440b of the inner conducting wires 430 and 440 to the length L3 of the second directional portions 430a and 440a of the inner conducting wires 430 and 440 may be 1: 6 to 9.

In addition, when the solar cell module is viewed from a front view, a distance B1 from the frame 50 disposed at an upper portion of the solar cell module to the junction box 600 may be greater than the second gap A2 between the second directional portions 430a and 440a of the inner conducting wires 430 and 440 and the last solar cell 100EC of the inner cell string.

Further, when the solar cell module is viewed from the front view, the distance B1, as shown in (a) of FIG. 5, from the frame 50 disposed at the upper portion of the solar cell module to the junction box 600 may be greater than a distance B2, as shown in (b) of FIG. 5, from the frame 50 disposed at a lower portion of the solar cell module to the last solar cell 100EC of the each cell string. This is to minimize interference with the frame 50 when the junction box 600 is disposed at the upper portion of the back side of the module during the module manufacturing process.

Also, in (a) of FIG. 5, a first conducting wire 410 has one end connected to the plurality of conductive wirings 300 connected to a last solar cell 100EC of an outermost cell string of the each cell string and another end connected to the junction box 600, and a second conducting wire 440 has one end connected to the plurality of conductive wirings 300 connected to a last solar cell 100EC of an inner cell string of the each cell string and another end connected to the junction box 600. In this instance, a length of the plurality of conductive wirings 300 connected to the last solar cell 100EC of the outermost cell string of the each cell string is greater than a length of the plurality of conductive wirings 300 connected to the last solar cell of the inner cell string of the each cell string.

That is, as shown in FIG. 7, the frame 50 may include a first portion 50a, a second portion 50b, a third portion 50c, and a fourth portion 50d.

Here, the first portion 50a of the frame 50 may be disposed to cover a front edge portion of the front transparent member 10.

The second portion 50b may extend in a thickness direction z of the module which intersects with a width direction x of the first portion 50a from an end of the first portion 50a, and may be disposed to cover sides of the front transparent member 10, the sealing members 20 and 30, and the back member 40.

The third portion 50c may extend from the second portion 50b in the same direction as the width direction x of the first portion 50a, and may be disposed to cover a back edge portion of the back member 40.

In addition, the fourth portion 50d may intersect with the width direction x of the second portion 50b from an end of the second portion 50b, and may extend in an inner direction x of the module in parallel with the first and second portions 50a, 50b.

Here, the fourth portion 50d may function as a module supporting portion for fixing the module to a specific position of a building roof or a wall surface. For fixing the module, a width L50d of the fourth portion 50d may be greater than a width of the first portion 50a.

In this instance, due to the fourth portion 50d of the frame 50, when the junction box 600 is disposed between the frame 50 and the solar cell 100 in the upper portion of the back side of the module, a distance from the first portion 50a of the frame 50 disposed at the upper portion of the module to the junction box 600 may be greater than a distance from the first portion 50a of the frame 50 disposed at the lower portion of the solar cell module to the last solar cell 100EC of the each cell string. Thus, interference due to the fourth portion 50d of the frame 50 during the module manufacturing process can be minimized.

Because of such a module structure, the module manufacturing process can be further facilitated.

However, the invention is not limited thereto. When the width L50d of the fourth portion 50d adjacent to the junction box 600 in the fourth portion 50d of the frame 50 disposed at the upper portion of the module is equal to the width of the first portion 50a, the distance B1 from the first portion 50a of the frame 50 disposed at the upper portion of the module to the junction box 600 may be less than the distance B2 from the first portion 50a of the frame 50 disposed at the lower portion of the solar cell module to the last solar cell 100EC of the each cell string.

In this instance, the area of the module can be further reduced, and the efficiency of the module can be further improved.

As described above, in the double-sided light receiving solar cell module according to the invention, in consideration of the feature that light is incident on the front and back sides of the module, the second directional portions 410a, 420a, 430a, and 440a of the conducting wires 410, 420, 430, and 440 are formed to overlap the junction box 600, so that the efficiency of the module can be maximized.

In FIG. 7, reference numeral 400 denotes the conducting wires 410, 420, 430 and 440. Reference numeral 400a denotes the second directional portions 410a, 420a, 430a and 440a. Reference numeral 400b denotes the first direction portions 410b, 420b, 430b, and 440b.

As shown in FIG. 7, the first directional portions 410b, 420b, 430b, and 440b of the conducting wires 410, 420, 430, and 440 penetrate the back member 40 and are connected to the junction box 600.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A double-sided light receiving solar cell module, comprising:
a plurality of solar cells connected to each other by a plurality of conductive wirings in a first direction to form each cell string;
a junction box configured to collect power generated from the plurality of solar cells and supply the collected power to outside; and
a plurality of conducting wires having one end connected to the plurality of conductive wirings connected to a last solar cell of the each cell string and another end connected to the junction box,
wherein the junction box and the plurality of conducting wires are disposed outside a projection area of the plurality of solar cells,
wherein the plurality of conducting wires include first directional portions extending in the first direction and second directional portions extending in a second direction intersecting with the first direction outside the projection area, and
wherein the second directional portions provided on at least one of the plurality of conducting wires overlap the junction box.

2. The double-sided light receiving solar cell module of claim 1, wherein the plurality of conductive wirings are arranged along the first direction, and
the plurality of conductive wirings connected to the last solar cell of the each cell string are connected to the second directional portions of the plurality of conducting wires.

3. The double-sided light receiving solar cell module of claim 1 or 2, wherein the plurality of conducting wires include:
outer conducting wires connected to a conductive wiring connected to a last solar cell of an outermost cell string located on an outermost side of the each cell string, and
inner conducting wires connected to a conductive wiring connected to a last solar cell of an inner cell string located inside the outermost cell string.

4. The double-sided light receiving solar cell module of claim 3, wherein the outer conducting wires and the inner conducting wires each include the second directional portions, and
a first gap between the second directional portions of the outer conducting wires and the last solar cell of the outermost cell string is greater than a second gap between the second directional portions of the inner conducting wires and the last solar cell of the inner cell string.

5. The double-sided light receiving solar cell module of claim 4, wherein a difference between the first gap and the second gap is greater than a line width of the inner conducting wires, and is less than twice the line width of the inner conducting wires.

6. The double-sided light receiving solar cell module of claim 4 or 5, wherein an outermost protruding length of the conductive wiring connected to the last solar cell of the outermost cell string is longer than an inner protruding length of the conductive wiring connected to the last solar cell of the inner cell string.

7. The double-sided light receiving solar cell module of claim 6, wherein the outermost protruding length is greater than 1.5 times the inner protruding length, and less than three times the inner protruding length.

8. The double-sided light receiving solar cell module of any one preceding claim, wherein a line width of each of the plurality of conducting wires is greater than a line width of each of the conductive wirings.

9. The double-sided light receiving solar cell module of any one preceding claim, wherein a ratio of the line width of each of the plurality of conductive wirings to the line width of each of the plurality of conducting wires is 1:15 to 25.

10. The double-sided light receiving solar cell module of any one preceding claim, wherein the plurality of conducting wires each further include the first directional portions extending in the first direction intersecting with the second directional portions at ends of the second directional portions, and
a ratio of the first directional portions to the second directional portions is 1: 6 to 15.

11. The double-sided light receiving solar cell module of any one preceding claim, wherein the solar cell module further includes:
a front transparent member disposed on a front side of the plurality of solar cells;
a back member disposed on a back side of the plurality of solar cells;
sealing members disposed between the plurality of solar cells and the front transparent member and disposed between the plurality of solar cells and the back member; and
a frame disposed to surround outer edge portions of the front transparent member, the sealing members, and the back member,
wherein the back member is transparent.

12. The double-sided light receiving solar cell module of claim 11, wherein the junction box is disposed at an upper portion of a back side of the solar cell module, and
when the solar cell module is viewed from a front view, a distance from the frame disposed at an upper portion of the solar cell module to the junction box is greater than a distance from the frame disposed at a lower portion of the solar cell module to the last solar cell of the each cell string.

13. The double-sided light receiving solar cell module of claim 11 or 12, wherein the frame includes:
a first portion disposed to cover a front edge portion of the front transparent member;
a second portion extending from an end of the first portion, and disposed to cover sides of the front transparent member, the sealing members, and the back member; and
a third portion extending from the second portion, and disposed to cover a back edge portion of the back member.

14. The double-sided light receiving solar cell module of claim 11, wherein the first directional portion included in each of the plurality of conducting wires penetrate the back member and are connected to a terminal provided in the junction box, and
wherein the front transparent member includes a glass material and the back member includes a resin material that is lighter than the glass material, and
wherein when the solar cell module is viewed from a front view, a distance from the frame disposed at an upper portion of the solar cell module to the junction box is greater than a second gap between second directional portions of inner conducting wires and a last solar cell of an inner cell string.

15. The double-sided light receiving solar cell module of any one of claims 4 to 14, wherein the plurality of solar cells are spaced apart in the first direction in the each cell string, and a gap of the plurality of solar cells in the first direction is less than the second gap.
